# EUROPEAN PATENT SPECIFICATION

(11) **EP 2 315 314 B1**
(45) Date of publication and mention of the grant of the patent: **31.10.2012**
(21) Application number: 10746234.3
(22) Date of filing: 24.02.2010
(51) Int. Cl.: C09J 7/02, H01R 4/04, H05K 3/32, B65H 18/28

(54) **REEL FOR ADHESIVE TAPE**
KLEBEBANDROLLE
ROULEAU DE RUBAN ADHÉSIF

(30) Priority: 27.02.2009 JP 2009045969
(43) Date of publication of application: 27.04.2011
(73) Proprietor: Hitachi Chemical Company, Ltd., Tokyo 163-0449 (JP)
(72) Inventor: TATSUZAWA Takashi, Chikusei-shi Ibaraki 308-8524 (JP); SEKI Takashi, Chikusei-shi Ibaraki 308-8524 (JP); KOBAYASHI Kouji, Chikusei-shi Ibaraki 308-8524 (JP); FUJINAWA Tohru, Chikusei-shi Ibaraki 308-8524 (JP); ARIFUKU Motohiro, Chikusei-shi Ibaraki 308-8524 (JP); SEKI Kotaro, Chikusei-shi Ibaraki 308-8524 (JP)
(74) Representative: HOFFMANN EITLE
(86) International application number: PCT/JP2010/052877
(87) International publication number: WO 2010/098354

(56) References cited:
- EP-A1- 2 017 315
- WO-A2-02/44294
- JP-A- 2001 284 005
- JP-A- 2005 336 447
- JP-A- 2006 015 621
- US-A1- 2006 003 161

## Description

### Technical Field

The present invention relates to a bonding-material reel which includes a tape for circuit connection having a tape-shaped base material and an adhesive layer formed on one surface of the base material, and a core around which this tape for circuit connection is wound.

### Background Art

An anisotropic conductive film (ACF: Anisotropic Conductive Film) is used as a connecting material for electrically connecting members to be connected having a large number of electrodes to each other to manufacture a circuit-connected body. The anisotropic conductive film is a connecting material which electrically connects and mechanically fixes the electrodes, that face to each other so that the electrodes are kept in a conductive state and adjacent electrodes are kept insulated from each other, when the member to be connected such as a semiconductor device including IC and LSI, or the package, is connected to a substrate such as a printed wiring board, a glass substrate for LCD and a flexible printed circuit board. A connecting material such as a non-conductive film (NCF: Non-Conductive film) other than the anisotropic conductive film is known.

The above described connecting material contains an adhesive component containing a thermosetting resin, and electroconductive particles which are blended as needed, in the case of the anisotropic conductive film, and is formed in a film shape on a base material such as a polyethylene terephthalate film (PET). A bonding-material reel is manufactured by cutting the source material of the film formed on the base material into the tape shape having such a width as to be suitable for the application, and winding the tape around a core material (see Patent Literature 1).

### Citation List

### Patent Literature

Patent Literature 1: Japanese Patent Application Laid-Open No. 2003-34468

EP 2 017 315 A1 relates to an adhesive tape comprising a tape-like base and an adhesive material provided on a main surface of the base. The adhesive tape is described to be used for bonding and fixing circuit boards to electronic components. Furthermore, the adhesive tape is wound around a reel.

### Summary of Invention

### Technical Problem

By the way, there is a phenomenon which is referred to as blocking, as one reason of lowering the connection reliability of a circuit-connected body. The blocking is such a phenomenon that an adhesive layer is transferred onto the back surface of the base material when the tape for circuit connection is pulled out from a reel and is used. If this phenomenon occurs, a required amount of the adhesive layer cannot be placed at a predetermined position on a member to be connected, and the connecting portion may be insufficiently electrically connected or mechanically fixed.

The present inventors focused on that the above described phenomenon tended to easily occur in a stage when the remainder of the tape for circuit connection became little, which had been wound around the reel, and made an investigation on the improvement. As a result, the present inventors found out that this phenomenon was likely to occur due to a bonded portion between the tape for circuit connection and an end tape. The end tape is a tape to be bonded to the terminal end of the tape for circuit connection, and connects the tape for circuit connection with the core.

The end tape has a role of reducing the amount of the adhesive layer which would be discarded without being used. Specifically, a pressure bonding device to be used for the manufacture of the circuit-connected body has a predetermined distance between a position of the mounted bonding-material reel and a position at which a pressure bonding operation is conducted. For this reason, if a reel is used in which the tape for circuit connection has been directly wound on the core, when the winding-off operation is finished and the reel is replaced by a new reel, the remaining adhesive layer is discarded without being used.

The present invention has been designed with respect to the above described circumferences, and the object is to provide a bonding-material reel which can sufficiently inhibit the adhesive layer from transferring onto the back surface of the base material, when the tape for circuit connection in a wound state is pulled out, and is useful for manufacturing the circuit-connected body having superior connection reliability.

### Solution to Problem

The bonding-material reel according to the present invention includes a tape for circuit connection having a tape-shaped base material and an adhesive layer formed on one surface of the base material, and a core around which the tape for circuit connection is wound, wherein the tape for circuit connection has an end tape which has been bonded to the terminal end, a region in which the adhesive layer is not formed over at least one reel length of the core toward the start end of the tape for circuit connection from the terminal end thereof, and a cover tape which is provided so as to cover the region.

As was described above, the tape for circuit connection has the region in which the adhesive layer is not formed over at least one reel length of the core toward the start end of the tape for circuit connection from the terminal end thereof. Because the bonding-material reel has such a structure, the region is positioned directly above the bonded portion of the tape for circuit connection to the end tape in such a state that the tapes are wound around the core. The bonded portion is covered with the region in which the adhesive layer is not formed, so even when there is some degree of unevenness or the like in the bonded portion, the occurrence of the blocking originating in the unevenness can be sufficiently inhibited.

The cover tape can be used for detecting that the remainder of the tape for circuit connection which is wound on the reel is little. In order to automatically detect the cover tape with an imaging device or the like, it is preferable that the hue of the cover tape is different from that of the adhesive layer. In addition, the cover tape may bond the tape for circuit connection to the end tape. In other words, the cover tape may extend even to the tip part side of the end tape, and may bond the terminal end of the tape for circuit connection to the tip part of the end tape.

In the present invention, it is preferable that the tape for circuit connection has a sticky tape provided so as to cover the terminal end of the tape for circuit connection and the tip part of the end tape. By using the sticky tape, the tape for circuit connection can be bonded to the end tape by higher strength. From the viewpoint of achieving higher bonding strength, the tape for circuit connection and the end tape may be bonded with the use of the sticky tape and the cover tape.

In the present invention, it is preferable that at least one surface of the end tape has been subjected to non-slip processing. Thereby, the slippage between the outer surface and the inner surface of the end tape which abut on each other in a state of being wound on the core can be made difficult to occur. As a result, the tape for circuit connection having a desired length can be pulled out with sufficiently high precision.

### Advantageous Effects of Invention

The bonding-material reel according to the present invention can sufficiently inhibit an adhesive layer from being transferred onto the back surface of a base material, when a tape for circuit connection in a wound state is pulled out, and can manufacture a circuit-connected body having superior connection reliability.

### Brief Description of Drawings

Figure 1 is a perspective view illustrating one embodiment of a bonding-material reel according to the present invention.
Figure 2 is a sectional view illustrating a state in which the bonding-material reel of Figure 1 is mounted on the rotary shaft of a pressure bonding device.
Figure 3 is a schematic sectional view illustrating one example of an anisotropic conductive tape.
Figure 4 is a schematic sectional view illustrating the terminal end of an anisotropic conductive tape according to a first embodiment of the present invention.
Figure 5 is a schematic sectional view illustrating a modified example of the terminal end illustrated in Figure 4.
Figure 6 is a schematic sectional view illustrating a process of pulling out an anisotropic conductive tape from a reel according to Comparative example 1.
Figure 7 is a schematic sectional view illustrating one example of a circuit-connected body in which the circuit electrodes are connected to each other.
Figure 8 is a schematic sectional view illustrating one example of a method for manufacturing a circuit-connected body.
Figure 9 is a schematic sectional view illustrating the terminal end of an anisotropic conductive tape according to a second embodiment of the present invention.
Figure 10 is a schematic sectional view illustrating a process of pulling out an anisotropic conductive tape from a reel according to Comparative example 2.

### Description of Embodiments

Preferred embodiments according to the present invention will be described below with reference to the attached drawings. For information, in the description for the drawings, the same reference numerals will be put on the same elements and overlapping descriptions will be omitted. In addition, dimensional ratios in the drawings do not necessarily match those of the described article, for the sake of convenience of the drawings.

### <First embodiment>

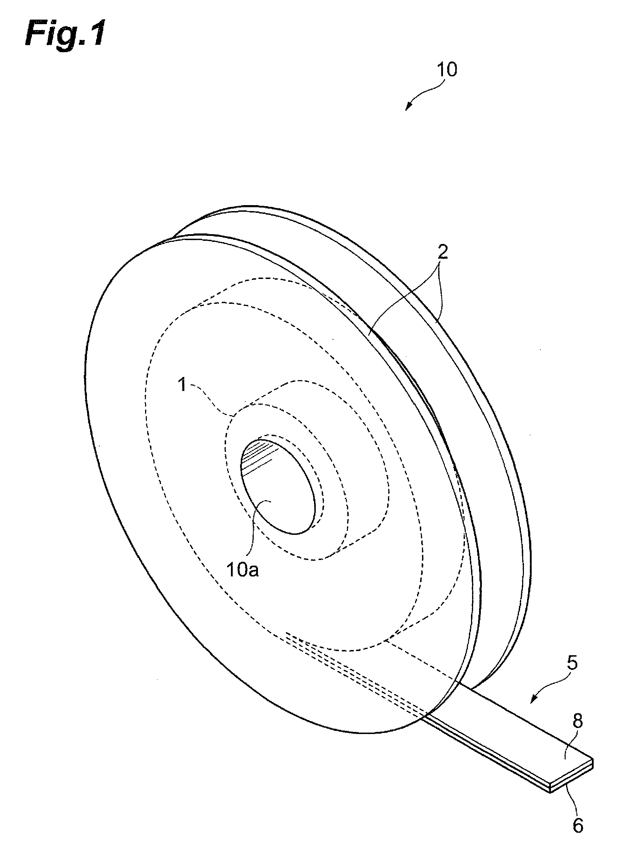

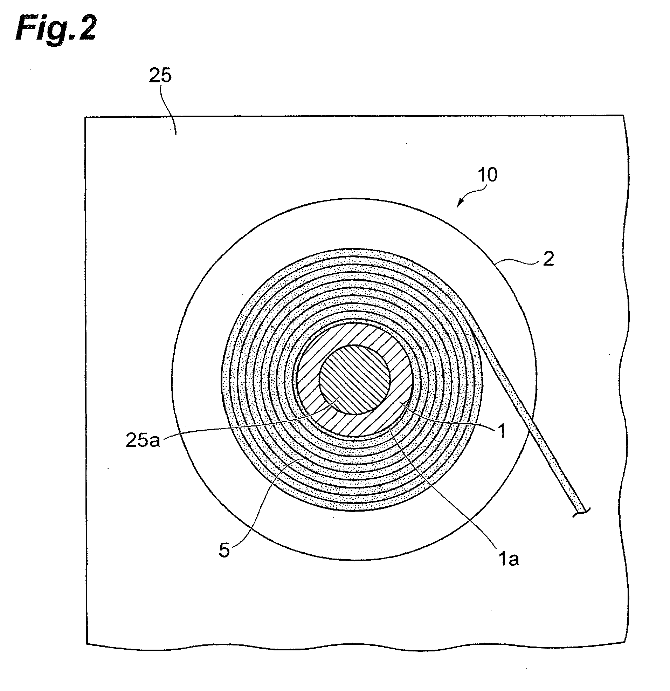

A bonding-material reel 10 illustrated in Figure 1 includes a cylindrical core 1, and circular side plates 2 which are provided on both end faces in the shaft direction of the core 1, respectively. As is illustrated in Figure 2, an anisotropic conductive tape 5 is wound on the outer surface 1a of the core 1 to constitute a wound body. The bonding-material reel 10 has a shaft hole 10a for being mounted on the rotary shaft 25a of a pressure bonding device 25. The outer diameter of the core 1 is not limited in particular, but is preferably 4 to 15 cm from the viewpoint of handlability.

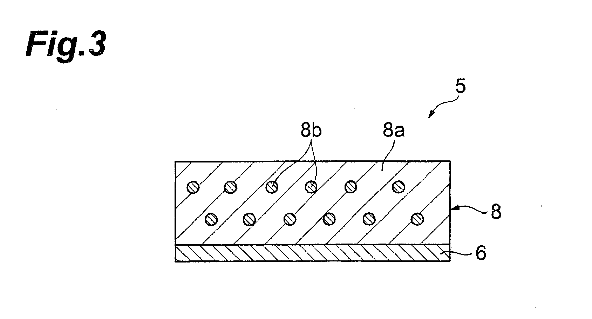

The anisotropic conductive tape 5 includes a tape-shaped base material 6, and an adhesive layer 8 which is formed on one surface of the base material 6, as is illustrated in Figure 3.

The length of the base material 6 is approximately 1 to 400 m, and preferably is 50 to 300 m. The thickness of the base material 6 is approximately 4 to 200 µm, and preferably is 20 to 100 µm. The width of the base material 6 is approximately 0.5 to 30 mm, and preferably is 0.5 to 3.0 mm. The length, the thickness and the width of the base material 6 are not limited to the above described ranges. In addition, the width of the base material 6 is preferably the same as that of the adhesive layer 8 which is formed on the base material 6, or wider than that of the adhesive layer 8.

The base material 6 can employ various tapes formed, for instance, from polyethylene terephthalate, polyethylene naphthalate, polyethylene isophthalate, polybutylene terephthalate, polyolefin, polyacetate, polycarbonate, polyphenylene sulfide, polyamide, an ethylene-vinyl acetate copolymer, polyvinyl chloride, polyvinylidene chloride, synthetic rubber, a liquid crystal polymer and the like. However, materials constituting the base material 6 are not limited to these. In addition, a material of which the surface to abut the adhesive layer 8 has been subjected to releasing treatment may be used as the base material 6.

The adhesive layer 8 is formed from an adhesive composition, and this adhesive composition contains, for instance, an adhesive component 8a and electroconductive particles 8b. The thickness of the adhesive layer 8 may be appropriately selected according to the types of the adhesive component to be used and an article to be bonded, and the like, but preferably is 5 to 100 µm, and more preferably is 10 to 40 µm. The width of the adhesive layer 8 may be adjusted according to the application to be used, but is approximately 0.5 to 5 mm and preferably is 0.5 to 3.0 mm.

A material showing curability by heat or light can be widely applied to the adhesive component 8a of the adhesive layer 8, and an epoxy-based adhesive or an acrylic-based adhesive can be used. A cross-linkable material is preferably used because of being superior in heat resistance and moisture resistance after having been connected. Among them, the epoxy-based adhesive which contains an epoxy resin which is a thermosetting resin as a main component is preferable because of being capable of being cured in a short period of time, having adequate connection workability, being superior in adhesiveness due to its molecular structure and the like.

Specific examples of the epoxy-based adhesive include adhesives that contain an epoxy resin with a high molecular weight, a solid epoxy resin or a liquid epoxy resin, or an epoxy resin formed by modifying the above epoxies with a urethane resin, a polyester resin, an acrylic rubber, a nitrile rubber (NBR), synthetic linear polyamide and the like, as a main component. The epoxy-based adhesives are generally formed by adding a curing agent, a catalyst, a coupling agent, a filler and the like to the above described epoxy which is a main component.

Specific examples of the acrylic-based adhesive include a polymer or a copolymer which contains at least one among acrylic acid, an acrylic ester, a methacrylic ester and acrylonitrile as a monomer component. According to the investigation of the present inventors, when the acrylic-based adhesive is used as the adhesive component 8a, the adhesive layer 8 tends to be easily transferred onto the back surface of the base material 6, compared to the case in which the epoxy-based adhesive has been used.

When an IC chip is packaged on a glass substrate or a flexible printed circuit board (FPC), it is preferable to blend a component of showing a relaxation action for an internal stress with the adhesive component, from the viewpoint of reducing the warp of the substrate, which is caused by a difference between the coefficients of liner thermal expansion of the IC chip and the substrate. Specifically, it is preferable to blend an acrylic rubber or an elastomer component in the adhesive component. A radical-curing-base adhesive as described in WO 98/44067 can also be used.

The electroconductive particles 8b are dispersed in the adhesive component 8a. The electroconductive particles 8b include, for instance, a particle of a metal such as Au, Ag, Pt, Ni, Cu, W, Sb, Sn and solder, and carbon. Alternatively, a coated particle may also be used which contains glass, ceramic, plastic and the like with non-conductivity as a nucleus, and makes the nucleus coated with the above described metal or carbon. The average particle diameter of the electroconductive particles 8b is preferably 1 to 18 µm, from the viewpoint of dispersibility and electroconductivity. In addition, an insulation-coated particle may be used which is formed by coating the electroconductive particle with an insulation layer, and the electroconductive particle and the insulative particle may be concomitantly used, from the viewpoint of enhancing the insulation properties between adjacent electrodes.

The blend ratio of the electroconductive particles 8b is preferably 0.1 to 30 parts by volume with respect to 100 parts by volume of the adhesive component contained in the adhesive layer 8, and more preferably is 0.1 to 10 parts by volume. When the blend ratio is less than 0.1 parts by volume, connection resistance between the electrodes facing to each other tends to be high. When the blending ratio exceeds 30 parts by volume, a short circuit between adjacent electrodes tends to be easily formed. For information, the adhesive layer 8 may be constituted only by the adhesive component 8a without being blended with the electroconductive particles 8b, though depending on the application of the anisotropic conductive tape 5.

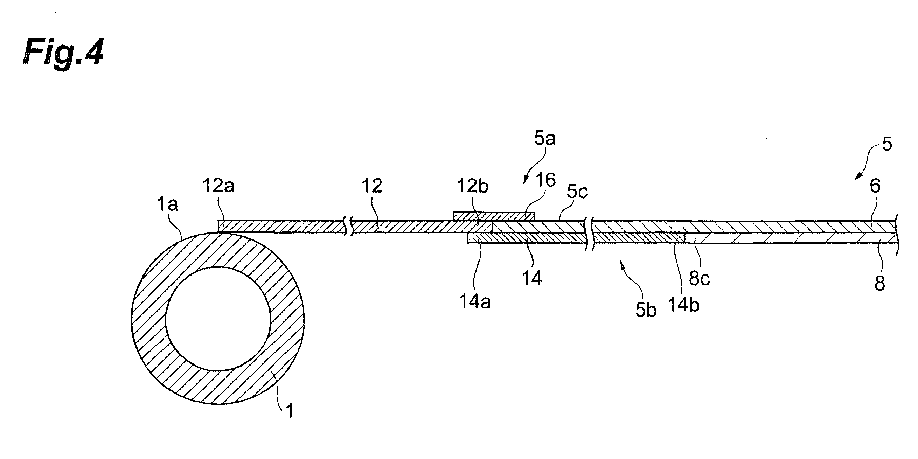

Next, the structure of the terminal end 5a of the anisotropic conductive tape 5 will be described below with reference to Figure 4. As is illustrated in Figure 4, the terminal end 5a of the anisotropic conductive tape 5 is constituted by an end tape 12, a cover tape 14 and a sticky tape 16.

The end tape 12 is a tape which connects the anisotropic conductive tape 5 with a core 1, and its terminal end 12a is fixed to the outer surface 1a of the core 1. The terminal end 12a can be fixed to the outer surface 1a with a double-stick tape (product made by Teraoka Seisakusho Co., Ltd., for instance). On the other hand, the tip part 12b of the end tape 12 is bonded to the terminal end 5a of the anisotropic conductive tape 5 by the cover tape 14 and the sticky tape 16.

The length of the end tape 12 is not limited in particular, and may be appropriately set according to a structure of a pressure bonding device 25 and the like, for instance, according to a predetermined distance between a rotary shaft 25a which mounts an bonding-material reel 10 thereon and a position at which a pressure bonding operation is conducted. The length of the end tape 12 is approximately 0.5 to 5 m, and preferably is 1 to 3 m. The thickness of the end tape 12 may be appropriately set according to a required strength and the like, but is preferably 10 to 100 µm, and more preferably is 30 to 70 µm. The width of the end tape 12 may be set so as to match the width of the base material 6 or the adhesive layer 8, is approximately 0.5 to 5 mm, and is preferably 0.5 to 3.0 mm.

The material constituting the end tape 12 includes a material similar to the material constituting the above described base material 6 (polyethylene terephthalate, for instance).

At least one surface of the end tape 12 is preferably subjected to non-slip processing. Thereby, a slippage between the outer surface and the inner surface of the end tape 12 which abut on each other in a state of being wound around the core 1 can be made difficult to occur. As a result, the anisotropic conductive tape 5 having a desired length can be pulled out with sufficiently high precision. The non-slip processing is particularly useful when the length of the end tape 12 is 1 m or longer. For information, specific examples of the non-slip processing include emboss processing for the surface of the end tape 12, and the application of rubber or the like onto the surface.

The cover tape 14 is a tape for covering a region 5b in which the adhesive layer 8 of the anisotropic conductive tape 5 is not formed. The cover tape 14 can be used for detecting that the remainder of the anisotropic conductive tape 5 which has been wound around the core 1 is little. From the viewpoint that the cover tape is automatically detected by an imaging device or the like, the hue of the surface of the cover tape 14 is preferably different from that of the adhesive layer 8.

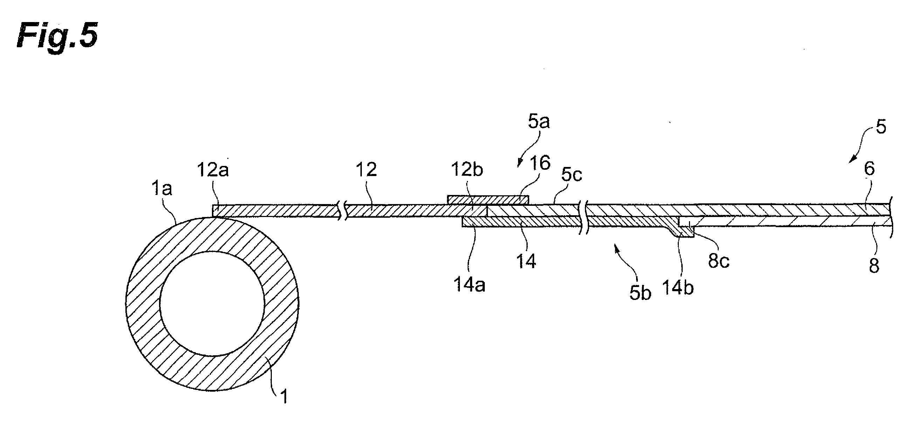

In the present embodiment, one end 14a of the cover tape 14 extends to the side of the tip part 12b of the end tape 12, and bonds the anisotropic conductive tape 5 to the end tape 12. In addition, it is preferable to make the other end 14b of the cover tape 14 extend so as to cover a terminal end 8c of the adhesive layer 8, from the viewpoint of preventing the peeling of the adhesive layer 8 (see Figure 5). A structure can also be employed in which a space is provided between the terminal end 8c of the adhesive layer 8 and the other end 14b of the cover tape 14.

The thickness of the cover tape 14 is preferably 10 to 100 µm, and more preferably is 30 to 70 µm. The width of the cover tape 14 may be adjusted so as to match the width of the base material 6 or the adhesive layer 8, is approximately 0.5 to 5 mm, and is preferably 0.5 to 3.0 mm.

The sticky tape 16 is a tape for enhancing a bonding strength between the anisotropic conductive tape 5 and the end tape 12. One surface of the sticky tape 16 is a sticky surface, and the sticky surface is stuck on the back surface 5c side of the anisotropic conductive tape 5, which is a bonded portion of the anisotropic conductive tape 5 and the end tape 12. When a sufficient bonding strength can be attained only by the cover tape 14, the sticky tape 16 may not be used. Or, when the sufficient bonding strength can be attained only by the sticky tape 16, the cover tape 14 may not be extended to the side of the tip part 12b of the end tape 12.

The length of the sticky tape 16 is approximately 5 to 30 mm, and is preferably 10 to 20 mm. The thickness of the sticky tape 16 may be appropriately set according to the required strength and the like, but is preferably 10 to 100 µm, and more preferably is 30 to 70 µm. In addition, the width of the sticky tape 16 may be adjusted so as to match the width of the base material 6 or the adhesive layer 8, is approximately 0.5 to 5 mm, and is preferably 0.5 to 3.0 mm.

In the present embodiment, as was described above, the region 5b in which the adhesive layer 8 does not exist is formed in the terminal end 5a of the anisotropic conductive tape 5. The region 5b is provided over at least one reel length of the core 1 toward the start end of the anisotropic conductive tape 5 from the terminal end thereof. The region 5b can be formed by removing the adhesive layer in a predetermined region of the anisotropic conductive film, in a process of cutting the anisotropic conductive film into a predetermined width to manufacture the anisotropic conductive tape 5, for instance.

The following effects are shown by forming the region 5b in which the adhesive layer 8 does not exist in the terminal end 5a of the anisotropic conductive tape 5. That is, when the anisotropic conductive tape 5 is in a state of being wound around the core 1, the region 5b is positioned directly above the bonded portion (sticky tape 16) between the anisotropic conductive tape 5 and the end tape 12. Because the bonded portion is covered with the region 5b, even when there is some degree of unevenness or the like in the bonded portion, the occurrence of the blocking originating in the unevenness can be sufficiently inhibited. The length of the provided region 5b is not limited in particular as long as the length is one reel length of the core 1 or longer, and may be two reel length or even three reel length. However, the length of the region 5b is preferably 0.5 m or shorter though depending on the diameter of the core 1. When the length of the region 5b exceeds 0.5 m, misalignment tends to occur when the cover tape 14 is affixed on the region 5b.

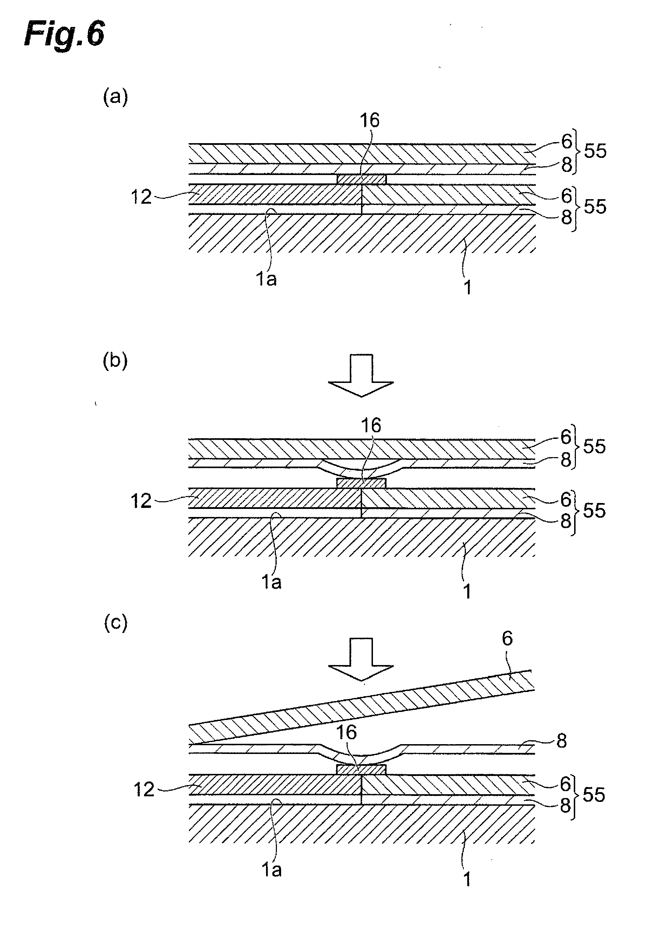

A blocking phenomenon of a bonding-material reel according to Comparative Example 1 will be described below with reference to Figure 6. The bonding-material reel according to Comparative Example 1 has a similar structure to that of the bonding-material reel 10 according to the first embodiment, except that the adhesive layer 8 is formed up to the bonded portion between the adhesive layer 8 and the end tape 12. In other words, the bonding-material reel according to Comparative Example 1 has a structure in which the anisotropic conductive tape 55 that does not have the region 5b in which the adhesive layer 8 does not exist and does not have the cover tape 14 which covers the region 5b is wound around the core 1. For information, in Figure 6, the outer surface 1a of the core 1 is drawn with a straight line for convenience, but actually forms an arc (see Figure 4).

As is illustrated in Figure 6(a), when the anisotropic conductive tape 55 is in a state of being wound around the core 1, the adhesive layer 8 exists also directly above the bonded portion (sticky tape 16) between the anisotropic conductive tape 55 and the end tape 12. When the anisotropic conductive tape 55 is pulled out in this state, the adhesive layer 8 can be peeled from a base material 6 due to the influence of the thickness of the sticky tape 16 or the tackiness agent (see Figure 6(b)). When the adhesive layer 8 is transferred onto the back surface of the base material 6 in the state, the adhesive layer 8 cannot be appropriately supplied to a pressure bonding device 25 (see Figure 6(c)). As a result, the connection reliability in a circuit-connected body can be insufficient.

### (Circuit-connected body)

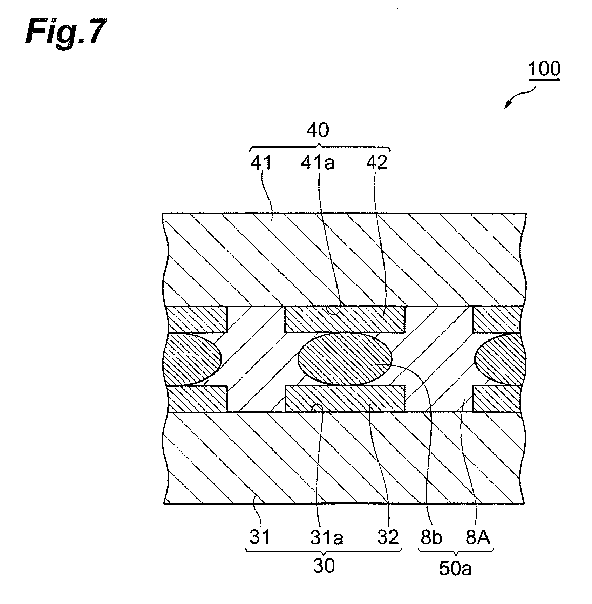

Next, a circuit-connected body which was manufactured by using the adhesive layer 8 of the bonding-material reel 10 according to the present embodiment as a circuit-connecting material will be described below. Figure 7 is a schematic sectional view illustrating a circuit-connected body having circuit electrodes connected to each other. The circuit-connected body 100 illustrated in Figure 7 has a first circuit member 30 and a second circuit member 40 facing to each other, and has a connecting portion 50a which is provided between the first circuit member 30 and the second circuit member 40, and connects these members to each other.

The first circuit member 30 has a circuit substrate 31, and a circuit electrode 32 formed on the main surface 31 a of the circuit substrate 31. The second circuit member 40 has a circuit substrate 41, and a circuit electrode 42 formed on the main surface 41 a of the circuit substrate 41.

Specific examples of the circuit member include a chip component such as a semiconductor chip (IC chip), a resistor chip and a condenser chip. These circuit members have a circuit electrode therein, and generally have a large number of circuit electrodes therein. Specific examples of the other circuit member to which the above described circuit member is connected include a wiring board such as a flexible tape having metal wiring thereon, a flexible printed wiring board, and a glass substrate having indium tin oxide (ITO) vapor-deposited thereon. The circuit members can be connected to each other efficiently with high connection reliability, by using the anisotropic conductive tape 5 that has been wound off from the bonding-material reel 10 which can discharge static electricity to the outside. Accordingly, the anisotropic conductive tape 5 according to the present embodiment is suitable for COG packaging (Chip On Glass) or COF packaging (Chip On Flex) of the chip component having a large number of fine connecting terminals (circuit electrodes) thereon onto the wiring board.

The surface of each circuit electrode 32 and 42 may be constituted by one substance selected from gold, silver, tin, ruthenium, rhodium, palladium, osmium, iridium, platinum and indium tin oxide (ITO), or may be constituted by two or more substances thereof. The material of the surface of the circuit electrodes 32 and 42 may be the same in all circuit electrodes or may be different.

A connecting portion 50a includes a cured substance 8A of an adhesive component 8a contained in the adhesive layer 8, and electroconductive particles 8b which are dispersed in the cured substance 8A. In the circuit-connected body 100, the circuit electrode 32 and the circuit electrode 42 facing to each other are electrically connected through the electroconductive particle 8b. In other words, the electroconductive particle 8b directly comes in contact with both of the circuit electrode 32 and the circuit electrode 42.

For this reason, connection resistance between the circuit electrodes 32 and 42 is sufficiently reduced, and the circuit electrode 32 and the circuit electrode 42 can be adequately electrically connected to each other. On the other hand, the cured substance 8A has electrical insulation properties, and the insulation properties between the adjacent circuit electrodes are secured. Accordingly, an electric current can smoothly pass through the circuit electrodes 32 and 42, and the circuit can sufficiently show its function.

### (Method for manufacturing circuit-connected body)

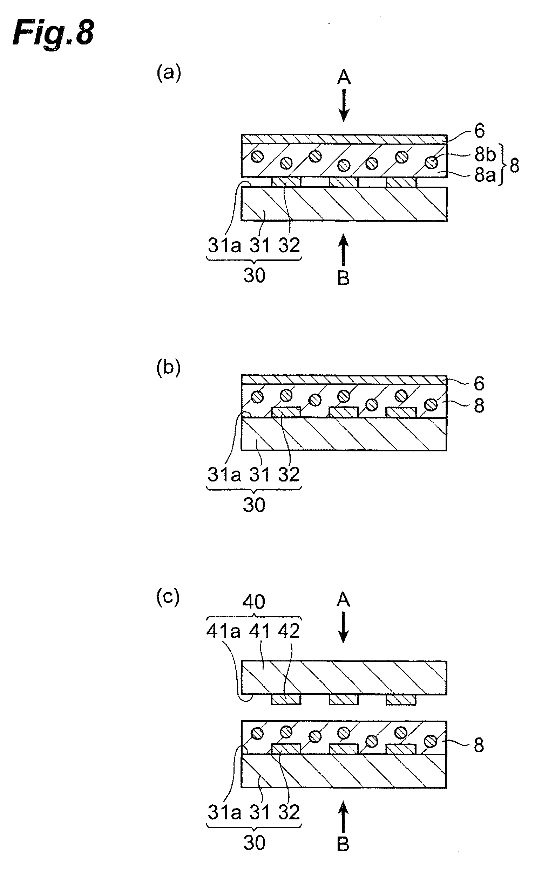

Next, a method for manufacturing a circuit-connected body 100 will be described below. Figure 8 is a process drawing for illustrating one embodiment of a method of manufacturing a circuit-connected body by schematic sectional views. In the present embodiment, the adhesive layer 8 of an anisotropic conductive tape 5 is cured by heating, and the circuit-connected body 100 is eventually manufactured.

Firstly, a bonding-material reel 20 is mounted on a rotary shaft of a connecting device (not-shown). The anisotropic conductive tape 5 is pulled out from this bonding-material reel 20 so that the adhesive layer 8 faces downward. The anisotropic conductive tape 5 is cut into a predetermined length, and is mounted on the main surface 31a of a circuit member 30 (Figure 8(a)).

Next, the adhesive layer 8 is temporarily connected to a first circuit member 30 by pressurizing the adhesive layer 8 in the directions of the arrows A and B in Figure 8(a) (Figure 8(b)). The pressure to be applied at this time is not limited in particular as long as the pressure is in a range of not damaging the circuit member, but is preferably set at 0.1 to 30.0 MPa in general. In addition, the adhesive layer 8 may be pressurized while being heated, and then, the heating temperature shall be set at a temperature at which the adhesive layer 8 is not substantially cured. The heating temperature is preferably set at 50 to 100°C in general. It is preferable to heat and pressurize the adhesive layer 8 for a range of 0.1 to 2 seconds.

After the base material 6 has been stripped off, as is illustrated in Figure 8(c), a second circuit member 40 is mounted on the adhesive layer 8 so that a second circuit electrode 42 faces to the first circuit member 30 side. Then, the whole members are pressurized in the directions of the arrows A and B in Figure 8(c) while the adhesives layer 8 is heated. The heating temperature at this time is set at a temperature at which the adhesive component 8a of the adhesives layer 8 can be cured. The heating temperature is preferably 60 to 180°C, more preferably is 70 to 170°C, and further preferably is 80 to 160°C. When the heating temperature is lower than 60°C, the curing speed tends to be slow, and when the heating temperature exceeds 180°C, an undesirable side reaction tends to easily progress. The heating period of time is preferably 0.1 to 180 seconds, more preferably is 0.5 to 180 seconds, and further preferably is 1 to 180 seconds.

When the adhesive component 8a is cured, a connecting portion 50a is formed and the circuit-connected body 100 as illustrated in Figure 7 is obtained. The connection condition is appropriately selected according to the application in which the circuit-connected body is used, the composition of the adhesive, and the circuit member. When an adhesive component which is cured by light is used as the adhesive component of the adhesive layer 8, the adhesive layer 8 may be appropriately irradiated with an active ray of light or an energy beam. The active rays of light include ultraviolet rays, visible light and infrared rays. The energy beams include an electron beam, X-rays, a gamma beam and a microwave.

When the bonding-material reel 10 according to the present embodiment is used, the bonding-material reel 10 can sufficiently inhibit blocking from occurring when the anisotropic conductive tape 5 in a state of being wound is pulled out. For this reason, the circuit-connected body 100 having superior connection reliability can be sufficiently stably manufactured. In addition, the anisotropic conductive tape 5 which has been wound around the bonding-material reel 10 can be used to the end, which can sufficiently reduce the adhesive composition which would be discarded without being used.

### <Second embodiment>

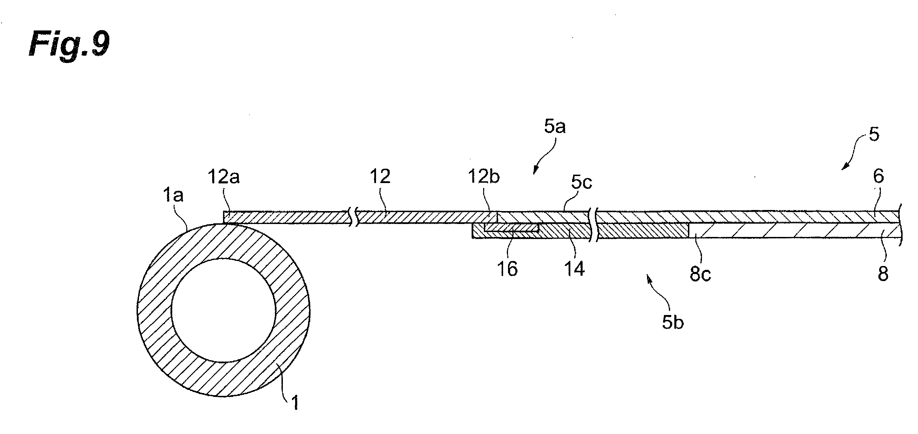

A bonding-material reel 20 according to a second embodiment will be described below with reference to Figure 9. The bonding-material reel 20 according to the present embodiment has a similar structure to that in the bonding-material reel 10 except that a sticky tape 16 which is provided in a bonded portion between an anisotropic conductive tape 5 and an end tape 12 and in the same side as that of a cover tape 14 is covered with the cover tape 14. In addition, when a sufficient bonding strength is attained only by the sticky tape 16, the cover tape 14 may not be extended even to the tip part 12b side of the end tape 12.

The bonding-material reel 20 has a structure in which a region 5b in which an adhesive layer 8 does not exist in the anisotropic conductive tape 5 over the same range as in the bonding-material reel 10 is formed, as is illustrated in Figure 9, and then, such a structure shows the following effects. That is, when the anisotropic conductive tape 5 is in a state of being wound around a core 1, the region 5b is positioned directly above the bonded portion between the anisotropic conductive tape 5 and the end tape 12. Because the bonded portion is covered with the region 5b, even when a gap is formed in the bonded portion by a tension applied to the anisotropic conductive tape 5, the occurrence of the blocking originating in the tackiness agent of the sticky tape 16 can be sufficiently inhibited.

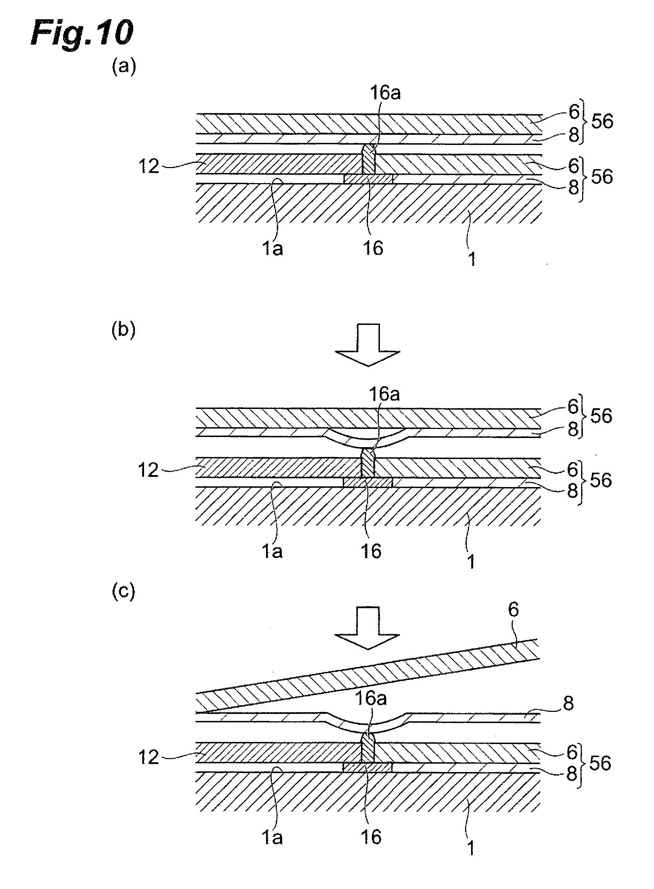

A blocking phenomenon of a bonding-material reel according to Comparative Example 2 will be described below with reference to Figure 10. The bonding-material reel according to Comparative Example 2 has a similar structure to that of the bonding-material reel 20 according to the second embodiment, except that the adhesive layer 8 is formed even in the bonded portion between the adhesive layer 8 and the end tape 12. In other words, the bonding-material reel according to Comparative Example 2 has a structure in which the anisotropic conductive tape 56 that does not have the region 5b in which the adhesive layer 8 does not exist and does not have the cover tape 14 which covers the region 5b is wound around the core 1. For information, in Figure 10, the outer surface 1a of the core 1 is drawn with a straight line for convenience, but actually forms an arc (see Figure 4).

As is illustrated in Figure 10(a), when the anisotropic conductive tape 56 is in a state of being wound around the core 1, the adhesive layer 8 exists also directly above the bonded portion between the anisotropic conductive tape 56 and the end tape 12. When the anisotropic conductive tape 56 is pulled out in this state, the adhesive layer 8 can be peeled from a base material 6 due to the influence of the thickness of the sticky tape 16 and a tackiness agent 16a (see Figure 10(b)). When the adhesive layer 8 is transferred onto the back surface of the base material 6, the adhesive layer 8 cannot be appropriately supplied to a pressure bonding device 25 (see Figure 10(c)). As a result, the connection reliability in a circuit-connected body may become insufficient.

In the above, preferred embodiments according to the present invention were described, but the present invention is not limited to the above described embodiments. The present invention can be modified in various ways in such a range as not to deviate from the scope of the invention.

For instance, in the above described embodiment, the case of having provided a hue difference between the cover tape 14 and the adhesive layer 8 was illustrated so as to detect that the amount of the remainder of the anisotropic conductive tape 5 is little, but the hue difference may be provided between the end tape 12 and the base material 6 or the adhesive layer 8. For instance, a black end tape may be used as the end tape 12. Alternatively, the hue difference may be provided between the surface and the rear surface of the end tape 12.

In addition, in the above described embodiment, the anisotropic conductive tape 5 was illustrated which had the adhesive layer 8 of a single layer structure, but the adhesive layer may have a multilayer structure. The anisotropic conductive tape having the adhesive layer of the multilayer structure can be manufactured by stacking a plurality of layers which have a different type of the adhesive component and the electroconductive particles from that of others or have a different content thereof, on the base material 6. For instance, an adhesive layer having a two-layer structure may be constituted by an electroconductive-particle non-containing layer which does not contain the electroconductive particles and an electroconductive-particle-containing layer which contains the electroconductive particles. For information, a similar adhesive component to the adhesive component of the above described adhesive layer 8 can be used as the adhesive component of the electroconductive-particle non-containing layer and the electroconductive-particle-containing layer.

Furthermore, in the above described embodiment, the anisotropic conductive tape 5 was illustrated as the tape for circuit connection, but the structure according to the above described embodiments 1 and 2 may be adopted also in the case of the non-conductive tape which has the adhesive layer 8 formed from the adhesive component 8a and does not contain the electroconductive particles 8b.

### Industrial Applicability

The bonding-material reel according to the present invention can sufficiently inhibit an adhesive layer from being transferred onto the back surface of the base material, when the tape for circuit connection in a wound state is pulled out, and can manufacture a circuit-connected body having superior connection reliability.

### Reference Signs List

1 ... core, 5 ... anisotropic conductive tape (Tape for circuit connection), 5a ... terminal end of anisotropic conductive tape, 5b ... region in which adhesive layer is not formed, 6 ... base material, 8 ... adhesive layer, 8A ... cured substance, 8a ... adhesive component, 8b ... electroconductive particles, 10 and 20 ... bonding-material reel, 12 ... end tape, 12b ... tip part of end tape, 14 ... cover tape, 16 ... sticky tape.

## Claims

1. A bonding-material reel (10) comprising:
a tape (5) for circuit connection having a tape-shaped base material (6) and an adhesive layer (8) formed on one surface of the base material (6); and
a core (1) around which the tape (5) for circuit connection is wound,
**characterized in that** the tape (5) for circuit connection has bonded to the terminal end (5a) there of an end tape (12) , a region (5b) in which the adhesive layer (8) is not formed over at least one reel length of the core (1) toward the start end of the tape (5) for circuit connection from the terminal end (5a) thereof, and a cover tape (14) which is provided so as to cover the region (5b).

2. The bonding-material reel (10) according to claim 1, wherein the cover tape (14) extends even to the tip part side (12b) of the end tape (12), and bonds the terminal end (5a) of the tape (5) for circuit connection to the tip part (12b) of the end tape (12).

3. The bonding-material reel (10) according to claim 1 or 2, wherein the end part (14b) in the adhesive layer side of the cover tape (14) extends so as to cover the terminal end (8c) of the adhesive layer (8).

4. The bonding-material reel (10) according to any one of claims 1 to 3, wherein the tape (5) for circuit connection further has a sticky tape (16) provided so as to cover the terminal end (5a) of the tape (5) for circuit connection and the tip part (12b) of the end tape (12).

5. The bonding-material reel (10) according to claim 4, wherein the sticky tape (16) is provided on the same side as the side of the cover tape (14) with respect to the base material (6) and is covered with the cover tape (14).

6. The bonding-material reel according to claim 4, wherein the sticky tape (16) is provided on the opposite side of the cover tape (14) with respect to the base material (6).

7. The bonding-material reel (10) according to any one of claims 4 to 6, wherein the sticky tape (16) has the length of 5 to 30 mm.

8. The bonding-material reel (10) according to any one of claims 4 to 7, wherein the base material (6) has a width of 0.5 to 5 mm, the adhesive layer (8) has a width of 0.5 to 5 mm, the end tape (12) has a width of 0.5 to 5 mm, the cover tape (14) has a width of 0.5 to 5 mm, and the sticky tape (16) has a width of 0.5 to 5 mm.

9. The bonding-material reel (10) according to any one of claims 1 to 8, wherein at least one surface of the end tape (12) has been subjected to non-slip processing.

10. The bonding-material reel (10) according to any one of claims 1 to 9, wherein the hue of the cover tape (14) is different from the hue of the adhesive layer (8).

11. The bonding-material reel (10) according to any one of claims 1 to 10, wherein the hue of the end tape (12) is different from the hue of the base material (6) or the adhesive layer (8).

12. The bonding-material reel (10) according to any one of claims 1 to 11, wherein the end tape (12) has a hue difference provided in between the surface and the rear surface.

13. The bonding-material reel (10) according to any one of claims 1 to 12, wherein the end tape (12) has a length of 0.5 to 5 m.

14. The bonding-material reel (10) according to any one of claims **1.** to 13, wherein the base material (6) has a length of 50 to 400 m.

15. The bonding-material reel (10) according to any one of claims 1 to 14, wherein the region (5b) in which the adhesive layer (8) is not formed has a length of 0.5 m or shorter.

16. The bonding-material reel (10) according to any one of claims 1 to 15, wherein the tape (5) for circuit connection is an anisotropic conductive tape or a non-conductive tape.

17. The bonding-material reel (10) according to any one of claims 1 to 16, wherein the core (1) has circular side plates (2) provided on both end faces in the shaft direction of the core (1), respectively.

## Patentansprüche

1. Klebematerial-Bandrolle (10), umfassend:
ein Band (5) zur Schaltkreisverbindung, das ein bandförmiges Basismaterial (6) und eine Adhäsivschicht (8), die auf einer Oberfläche des Basismaterials (6) gebildet ist, aufweist; und
einen Kern (1), um den das Band (5) zur Schaltkreisverbindung gewunden ist, **dadurch gekennzeichnet, dass** das Band (5) zur Schaltkreisverbindung ein an sein Abschlussende (5a) gebundenes Endband (12), eine Region (5b), in der die Adhäsivschicht (8) zumindest über eine Rollenlänge des Kerns (1) in Richtung des Anfangsendes des Bands (5) zur Schaltkreisverbindung von seinem Abschlussende (5a) aus nicht gebildet ist, sowie ein Abdeckungsband (14), das zur Abdeckung der Region (5b) angeordnet ist, aufweist.

2. Klebematerial-Bandrolle (10) gemäß Anspruch 1, worin das Abdeckungsband (14) sich zur Spitzenteilseite (12b) des Endbandes (12) erstreckt und das Abschlussende (5a) des Bandes zur Schaltkreisverbindung an dem Spitzenteil (12b) des Endbandes bindet.

3. Klebematerial-Bandrolle (10) gemäß Anspruch 1 oder 2, worin der Endteil (14b) der Adhäsivschichtseite des Abdeckungsbandes (14) sich so erstreckt, dass er das Abschlussende (8c) der Adhäsivschicht (8) abdeckt.

4. Klebematerial-Bandrolle (10) gemäß irgendeinem der Ansprüche 1 bis 3, worin das Band (5) zur Schaltkreisverbindung weiterhin ein klebriges Band (16) aufweist, das so angebracht ist, dass es das Abschlussende (5a) des Bandes (5) zur Schaltkreisverbindung und den Spitzenteil (12b) des Endbandes (12) abdeckt.

5. Klebematerial-Bandrolle (10) gemäß Anspruch 4, worin das klebrige Band (16) auf der gleichen Seite wie die Seite des Abdeckungsbandes (14) in Bezug auf das Basismaterial (6) angebracht ist und mit dem Abdeckungsband (14) abgedeckt ist.

6. Klebematerial-Bandrolle gemäß Anspruch 4, worin das klebrige Band (16) auf der gegenüberliegenden Seite des Abdeckungsbandes (14) in Bezug auf das Basismaterial (6) angebracht ist.

7. Klebematerial-Bandrolle (10) gemäß irgendeinem der Ansprüche 4 bis 6, worin das klebrige Band (16) eine Länge von 5 bis 30 mm hat.

8. Klebematerial-Bandrolle (10) gemäß irgendeinem der Ansprüche 4 bis 7, worin das Basismaterial (6) eine Breite von 0,5 bis 5 mm hat, die Adhäsivschicht (8) eine Breite von 0,5 bis 5 mm hat, das Endband (12) eine Breite von 0,5 bis 5 mm hat, das Abdeckungsband (14) eine Breite von 0,5 bis 5 mm hat, und das klebrige Band (16) eine Breite von 0,5 bis 5 mm hat.

9. Klebematerial-Bandrolle (10) gemäß irgendeinem der Ansprüche 1 bis 8, worin mindestens eine Oberfläche des Endbandes (12) einer Rutschfestigkeitsbehandlung unterzogen wurde.

10. Klebematerial-Bandrolle (10) gemäß irgendeinem der Ansprüche 1 bis 9, worin sich der Farbton des Abdeckungsbandes (14) vom Farbton der Adhäsivschicht (8) unterscheidet.

11. Klebematerial-Bandrolle (10) gemäß irgendeinem der Ansprüche 1 bis 10, worin sich der Farbton des Endbandes (12) vom Farbton des Basismaterials (6) oder der Adhäsivschicht (8) unterscheidet.

12. Klebematerial-Bandrolle (10) gemäß irgendeinem der Ansprüche 1 bis 11, worin das Endband (12) einen Farbton-Unterschied zwischen der Oberfläche und der rückseitigen Oberfläche aufweist.

13. Klebematerial-Bandrolle (10) gemäß irgendeinem der Ansprüche 1 bis 12, worin das Endband (12) eine Länge von 0,5 bis 5 m hat.

14. Klebematerial-Bandrolle (10) gemäß irgendeinem der Ansprüche 1 bis 13, worin das Basismaterial (6) eine Länge von 50 bis 400 m hat.

15. Klebematerial-Bandrolle (10) gemäß irgendeinem der Ansprüche 1 bis 14, worin die Region (5b), in der keine Adhäsivschicht (8) gebildet ist, eine Länge von 0,5 m oder kürzer hat.

16. Klebematerial-Bandrolle (10) gemäß irgendeinem der Ansprüche 1 bis 15, worin das Band (5) zur Schaltkreisverbindung ein anisotrop leitfähiges Band oder ein nicht-leitendes Band ist.

17. Klebematerial-Bandrolle (10) gemäß irgendeinem der Ansprüche 1 bis 16, worin der Kern (1) kreisförmige Seitenplatten (2) aufweist, die an beiden Endflächen in der Achsenrichtung des Kerns (1) angebracht sind.

## Revendications

1. Rouleau de matériau adhésif (10) comprenant :
une bande (5) pour connexion de circuit, ayant un matériau de base en forme de bande (6) et une couche adhésive (8) formée sur une surface du matériau de base (6) ; et
un noyau (1) autour duquel la bande (5) pour connexion de circuit est enroulée,
**caractérisé en ce que** la bande (5) pour connexion de circuit a, collée à l'extrémité terminale (5a) de celle-ci, une bande d'extrémité (12), une zone (5b) dans laquelle la couche adhésive (8) n'est pas formée sur au moins une longueur de rouleau du noyau (1) vers l'extrémité de départ de la bande (5) pour connexion de circuit depuis l'extrémité terminale (5a) de celle-ci, et une bande de couverture (14) qui est disposée de façon à recouvrir la zone (5b).

2. Rouleau de matériau adhésif (10) selon la revendication 1, dans lequel la bande de couverture (14) s'étend même jusqu'au côté de la partie de pointe (12b) de la bande d'extrémité (12) et colle l'extrémité terminale (5a) de la bande (5) pour connexion de circuit à la partie de pointe (12b) de la bande d'extrémité (12).

3. Rouleau de matériau adhésif (10) selon la revendication 1 ou 2, dans lequel la partie d'extrémité (14b) dans le côté de la couche adhésive de la bande de couverture (14) s'étend de façon à recouvrir l'extrémité terminale (8c) de la couche adhésive (8).

4. Rouleau de matériau adhésif (10) selon l'une quelconque des revendications 1 à 3, dans lequel la bande (5) pour connexion de circuit a en outre une bande collante (16), disposée de façon à recouvrir l'extrémité terminale (5a) de la bande (5) pour connexion au circuit et la partie de pointe (12b) de la bande d'extrémité (12).

5. Rouleau de matériau adhésif (10) selon la revendication 4, dans lequel la bande collante (16) est fournie sur le même côté que celui de la bande de couverture (14) relativement au matériau de base (6) et est recouverte par la bande de couverture (14).

6. Rouleau de matériau adhésif selon la revendication 4, dans lequel la bande collante (16) est fournie sur le côté opposé de la bande de couverture (14) relativement au matériau de base (6).

7. Rouleau de matériau adhésif (10) selon l'une quelconque des revendications 4 à 6, dans lequel la bande collante (16) a une longueur de 5 à 30 mm.

8. Rouleau de matériau adhésif (10) selon l'une quelconque des revendications 4 à 7, dans lequel le matériau de base (6) a une largeur de 0,5 à 5 mm, la couche adhésive (8) a une largeur de 0,5 à 5 mm, la bande d'extrémité (12) a une largeur de 0,5 à 5 mm, la bande de couverture (14) a une largeur de 0,5 à 5 mm, et la bande collante (16) a une largeur de 0,5 à 5 mm.

9. Rouleau de matériau adhésif (10) selon l'une quelconque des revendications 1 à 8, dans lequel au moins une surface de la bande d'extrémité (12) a été soumise à un traitement antidérapant.

10. Rouleau de matériau adhésif (10) selon l'une quelconque des revendications 1 à 9, dans lequel la teinte de la bande de couverture (14) est différente de la teinte de la couche adhésive (8).

11. Rouleau de matériau adhésif (10) selon l'une quelconque des revendications 1 à 10, dans lequel la teinte de la bande d'extrémité (12) est différente de la teinte du matériau de base (6) ou de la couche adhésive (8).

12. Rouleau de matériau adhésif (10) selon l'une quelconque des revendications 1 à 11, dans lequel la bande d'extrémité (12) a une différence de teinte entre la surface et la surface arrière.

13. Rouleau de matériau adhésif (10) selon l'une quelconque des revendications 1 à 12, dans lequel la bande d'extrémité (12) a une longueur de 0,5 à 5 m.

14. Rouleau de matériau adhésif (10) selon l'une quelconque des revendications 1 à 13, dans lequel le matériau de base (6) a une longueur de 50 à 400 m.

15. Rouleau de matériau adhésif (10) selon l'une quelconque des revendications 1 à 14, dans lequel la zone (5b) dans laquelle la couche adhésive (8) n'est pas formée a une longueur de 0,5 m ou moins.

16. Rouleau de matériau adhésif (10) selon l'une quelconque des revendications 1 à 15, dans lequel la bande (5) pour connexion de circuit est une bande conductrice anisotrope ou une bande non-conductrice.

17. Rouleau de matériau adhésif (10) selon l'une quelconque des revendications 1 à 16, dans lequel le noyau (1) a des plaques latérales circulaires (2) ménagées sur les deux faces d'extrémité dans la direction de l'axe du noyau, respectivement.
